# EUROPEAN PATENT SPECIFICATION

(11) **EP 0 330 708 B1**
(45) Date of publication and mention of the grant of the patent: **04.05.1994**
(21) Application number: 88103006.8
(22) Date of filing: 29.02.1988
(51) Int. Cl.: C30B 25/12, C23C 16/44

(54) **Apparatus for forming thin films**
Vorrichtung zur Herstellung von dünnen Filmen
Appareillage pour la formation de films minces

(43) Date of publication of application: 06.09.1989
(73) Proprietor: NIPPON KOKAN KABUSHIKI KAISHA, Tokyo 100 (JP)
(72) Inventor: Ohmura, Masanori Patent & Licence & Quality, Marunouchi Chiyoda-ku Tokyo (JP); Sakama, Hiroshi Patent & Licence & Quality, Marunouchi Chiyoda-ku Tokyo (JP); Araki, Kenji Patent & Licence & Quality, Marunouchi Chiyoda-ku Tokyo (JP); Kamio, Hiroshi Patent & Licence & Quality, Marunouchi Chiyoda-ku Tokyo (JP); Shima, Yoshinobu Patent & Licence & Quality, Marunouchi Chiyoda-ku Tokyo (JP)
(74) Representative: Popp, Eugen, Dr.

(56) References cited:
- EP-A- 0 147 967
- EP-A- 0 223 629
- EP-A- 0 325 663
- PATENT ABSTRACTS OF JAPAN, vol. 3, no. 86 (E-125), 24th July 1979, page 50 E 125; & JP-A-54 64 977

## Description

This invention relates to an apparatus for forming thin films such as a barrel type epitaxial growth apparatus used for manufacturing ultra LSIs.

With recent trend for increasing integration density and reducing size of semiconductor integrated circuits, it is frequently in practice to form an epitaxial layer through epitaxial crystal growth on a semiconductor wafer for MOS, for instance. There is also a trend that the thickness of the epitaxial layer is reduced with increasing size of the semiconductor substrate. Reaction apparatus for the epitaxial growth are roughly classified into three types, i.e., horizontal reaction tube type, vertical bell jar type and barrel type. Further, there is a recently developed hot wall type, which is a modification of the reduced pressure CVD. In these reaction apparatus, a suscepter for supporting a plurality of wafers is set in a reaction furnace held under a high temperature condition, and in this state a reaction fluid, which is such gas as silicon tetrachloride (SiCℓ₄) or silane, is supplied into the reaction furnace, whereby an epitaxial layer is formed on each wafer surface.

The European Patent Application, EP-A 0 253 663 discloses a film-forming apparatus comprising a reaction furnace having a reaction chamber therein, the furnace comprising a pair of susceptors substantially vertically positioned in the reaction chamber and having opposing sides separated by a specific distance. The apparatus also includes holding means for a plurality of objects to be subjected to film formation and means for relative rotation of the susceptors.

In a modification of the barrel type epitaxial growth apparatus, each wafer is heated from two sides for obtaining uniform heating. In this case, the wafer is heated from the back side by a high frequency induction coil through a suscepter, while the bell jar surface is provided with a metal coating film to radiate heat toward the wafer surface.

In order to obtain high quality epitaxial film it Is Important to maintain the thickness and resistance of the film uniform. In the barrel type apparatus noted above, however, it is impossible to control the temperature of each wafer or temperature of each portion of a wafer constituting each chip uniformly, and a non-uniform temperature distribution results. The reason for this is as follows. With the reaction fluid progressively supplied to and discharged from the reaction furnace under a high temperature condition, the temperature of the fluid, i.e., silane, and the molar concentration of a silicon-containing gas and a dopant gas are not the same in the neighborhood of the inlet and outlet of the furnace, that is, the temperature and molar concentration vary depending on the location of the wafer. Further, silane does not flow uniformly through the reaction furnace, but will sometimes form a vortex flow. In such a case, variations of temperature and molar concentration of gas will occur not with different wafers but with different portions of the same wafer. Still further, the amount of heat radiated from the metal coating film formed on the bell jar is reduced with the progress of the epitaxial growth, thus resulting in non-uniform temperature distribution. Furthermore, with the repetition of the epitaxial growth process, the metal coating film is deteriorated due to thermal fatigue. Non-uniform temperature distribution is further liable depending on the amount of the supplied reaction fluid.

Further, regarding the amount of wafers processed, an increase of the wafer size reduces the amount processed per cycle, leading to a cost increase of wafer.

An object of the invention is to provide an apparatus for forming thin films, which permits a high quality thin film having uniform thickness and resistance to be formed on a plurality of semiconductor wafers or like works in a single process.

In accordance with the present invention, an apparatus for forming thin films is provided as defined in the claims. The apparatus comprises a reaction furnace and a first and second susceptor, the first susceptor being coaxially disposed in the second hollow cup-shaped susceptor. The second susceptor is disposed to surround the first susceptor at a predetermined radial space therefrom and has an inner periphery capable of supporting a plurality of process works (preferably semiconductor wafers) such that they face the process works (preferably semiconductor wafers) supported on the outer surface of the first susceptor. The apparatus further comprises rotating means to establish relative rotation between the two susceptors, means for supplying a reaction fluid to the reaction and means for exhausting the reaction fluid.

Also in accordance with the invention, an apparatus as described above is provided, further comprising a pair of heat reflection members and heating means for heating the reaction fluid as defined in the claims. The heat reflection members are disposed in the reaction furnace between the outer periphery of the first susceptor and the inner periphery of the second susceptor, so that the members define the top and bottom of the space formed between the susceptors.

This invention can be more fully understood from the following detailed description when taken in conjunction with the accompanying drawings, in which:
Fig. 1 is a schematic sectional view showing one embodiment of the apparatus for forming thin films according to the invention;
Fig. 2 is a sectional view showing a modification of a gas supply ductline in the same apparatus; and
Fig. 3 is a perspective view showing another modification of the gas supply ductline in the same apparatus.

Now, an embodiment of the thin film formation apparatus according to the invention applied to a barrel type epitaxial growth apparatus for forming an epitaxial layer on silicon wafers, will be described.

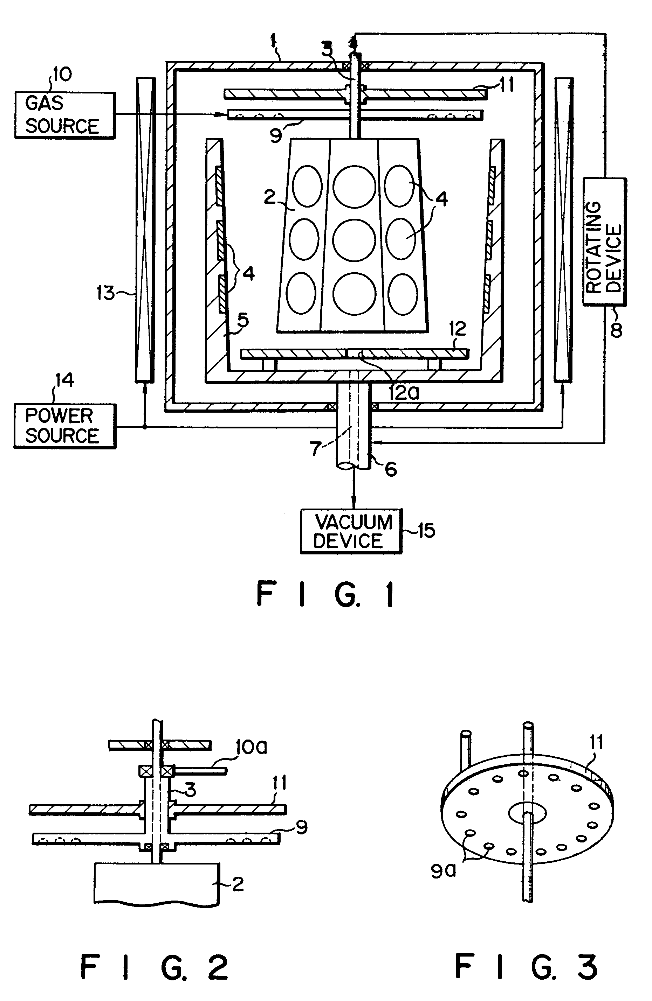

Fig. 1 shows the embodiment. Reference numeral 1 designates a reaction furnace or bell jar, which is a hollow cylindrical or oval member made of a heat-resistant material, e.g., quartz. In bell jar 1, first and second suscepters 2 and 5 are coaxially accommodated. First suscepter 2 has a substantially hexagonal sectional profile. Shaft 3 projects from the top of the center of this suscepter. Shaft 3 extends coaxially with suscepter 2 and penetrates the top center of bell jar 1 to the outside. It is rotatably supported by a bearing provided in the top wall of the bell jar. Suscepter 2 accurately has a hexagonal frust-conical profile. Its six side surfaces are slightly inclined such that they flare outwardly as one goes downwards. Each flat side surface is formed with circular wafer reception recesses. The number and locations of the wafer reception recesses can be suitably selected. In this embodiment, each side surface is formed with three vertically uniformly spaced-apart wafer reception recesses, that is, suscepter 2 has a total of 18 wafer reception recesses. The wafer reception recess preferably has a diameter slightly greater than the outer diameter of the wafer.

Second suscepter 5 has a hollow cylindrical shape closed at the bottom. First suscepter 2 is coaxially disposed in second suscepter 5. The inner surface of second suscepter 5 consists of six flat surfaces closely arranged side by side in the circumferential direction. These flat surfaces are slightly inclined such that they flare inwardly as one goes downwards. Each of the six inner surfaces is formed with three circular wafer reception recesses. It is to be understood that the direction of inclination of the side surfaces of first suscepter 2 is opposite to the direction of inclination of the inner side surfaces of second suscepter 5. The inclination of the peripheral surfaces with respect to a vertical axis is not essential but desired in order to let the suscepters support wafers 4 as process works satisfactorily with a simple construction. Hollow shaft 6 extends from the center of the bottom of second suscepter 5. Shaft 6 extends coaxially with suscepter 5 and penetrates the center of the bottom of bell jar 1. It is rotatably supported in the bell jar via a bearing provided in the bottom wall of the bell jar.

Shaft 6 is coupled to and rotated by rotating device 8 which is disposed outside bell jar 1. Rotating device 8 is of a well-known structure, for instance consisting of a motor and a gear train. It may rotate shafts 3 and 6 in opposite directions, or it may rotate these shafts in the same direction but at different speeds. As a further alternative, it may rotate only one of shafts 3 and 6.

Gas supply ductline or nozzle unit 9 is disposed in an upper portion of the interior of bell jar 1 for supplying a reaction gas, i.e., silicon tetrachloride gas. The gas supply ductline has a number of gas jet ports which are disposed above the space between suscepters 2 and 5. Gas supply ductline 9 is connected to gas source 10, which is disposed outside bell jar 1, and from which the reaction gas is supplied at a controlled rate.

Upper shaft 3 is provided with coaxial reflector 11 secured to it. Reflector 11 is disk-like in shape and made of a material capable of reflecting radiation heat, e.g., stainless steel. Second reflector 12 is secured to the bottom wall of second suscepter 5 such that it is spaced apart a predetermined distance from the bottom wall upper surface. It has central through hole 12a, through which the reaction gas is passed. Between first and second suscepters 2 and 5, there is formed an epitaxial growth space, which has its top and bottom defined by reflectors 11 and 12 and its periphery by first and second suscepters 2 and 5 and wafers supported thereby, that is, which is defined by radiation heat reflection surfaces.

Exhausting tube 7 extends through lower shaft 6. The exhausting tube has one end open at the center of the upper surface of the bottom wall of second suscepter 5 and the other end connected to vacuum device 15. Unnecessary gas is exhausted from the epitaxial growth space through the space surrounding second reflector 12 and central through hole 12a formed therein and then through exhausting tube 7.

High frequency induction heating coil 13 is disposed such that it surrounds bell jar 1. It is connected to power source 14 and supplied with predetermined power therefrom to heat the epitaxial growth space.

Now, the operation of the apparatus having the above construction will be described in connection with a case of forming an epitaxial growth layer silicon wafers 4.

First, wafers 4 are set in the recesses of first and second suscepters 2 and 5, and then these suscepters are rotated in opposite directions. At the same time, coil 13 is energized to heat the interior of bell jar 1 to a predetermined temperature. Further, silane as reaction gas is supplied from gas source 10 through gas supply ductline 9 into the epitaxial growth space in bell jar 1. As a result, the reaction gas is decomposed in the space, and silicon epitaxial layer is formed on silicon wafers 4. The excess of the decomposed gas is exhausted through exhausting tube 7 to the outside of bell jar 1. Since the surface of wafers 4 is a mirror surface, during the epitaxial growth the opposed wafers function as radiation heat source like opposed suscepters 2 and 5. Thus, uniform temperature distribution can be obtained among wafers 4 supported by suscepters 2 and 5. Further, since suscepters 2 and 5 are rotating in a face-to-face relation to each other, the reaction gas flowing through between these suscepters is agitated to be brought uniformly to individual wafers 4. With such uniformalization of the temperature and reaction gas flow, an epitaxial layer can be obtained, which has uniform thickness and resistance. Further, since two suscepters 2 and 5 are used, it is possible to form an epitaxial layer on a number of wafers at a time.

In the above embodiment, gas supply ductline 9 has been stationary. However, it is possible to use a gas supply ductline which is rotatable together with suscepter 2, as shown in Fig. 2. In this modification, shaft 3 is hollow and integral with gas supply ductline 9 such that the former and latter communicate with each other. Shaft 3 is connected via a rotary fluid joint to pipeline 10a from the gas source. Thus, the reaction gas is supplied from rotating supply gas ductline to the epitaxial gas growth space.

Fig. 3 shows a different modification of the supply gas ductline. In this case, supply gas ductline is formed in reflector 11. More specifically, reflector 11 is hollow, and its lower surface is formed with a plurality of gas jet ports 9a. A pipeline connected to the gas source projects from the top surface of reflector 11.

In the above embodiment, the suscepter surfaces for supporting wafers were slightly inclined so that they can support wafers during rotation. However, this wafer support means is by no means limitative. For example, the suscepter surfaces may be formed with ridges in lieu of the recesses so as to support the wafer periphery with the ridge. Further, the first suscepter is not limited to be of the hexagonal cylindrical or hexagonal conical shape, but it may of any other suitable shape so long as it can support wafers on its periphery. For example, a polygonal suscepter other than hexagonal may be used. Further, the suscepter surfaces need not be flat, if means for supporting wafers are provided. The second suscepter, like the first suscepter, is subject to various modifications. For example, if the upper surface of the bottom wall of the second suscepter is formed as a reflecting surface, the second reflector may be dispensed with. Instead of using a high frequency induction heating coil, electric-resisting means and a lamp may be used for heating suscepters.

## Claims

1. An apparatus for forming thin films, comprising:
a reaction furnace (1); characterized by comprising
a first susceptor (2) disposed in said reaction furnace and having an outer periphery capable of supporting a plurality of process works (4) and being coaxially disposed in
a second hollow cup-shaped susceptor (5) which is disposed in said reaction furnace such as to surround said first susceptor (2) at a predetermined radial space therefrom and having an inner periphery capable of supporting a plurality of process works (4) such that these process works face process works supported by said first susceptor (2);
rotating means (8) for causing relative rotation of said first and second susceptors (2, 5) to each other;
means (9, 10) for supplying a reaction fluid to the space in said reaction furnace between the outer periphery of said first susceptor and inner periphery of said second susceptor; and
means (7, 15) for exhausting the reaction fluid from the space in said reaction furnace between the outer periphery of said first susceptor and the inner surface of said second susceptor.

2. The apparatus according to claim 1, characterized in that the outer periphery of said first susceptor (2) has a plurality of flat surfaces arranged side by side in the peripheral direction, each of said flat surfaces being capable of supporting at least one process work.

3. The apparatus according to claim 2, characterized in that the inner periphery of said second susceptor (5) has a plurality of flat surfaces arranged side by side in the circumferential direction, each of said flat surfaces being capable of supporting at least one process work.

4. The apparatus according to claim 3, characterized in that the flat surfaces of said first and second susceptors (2, 5) have recesses for receiving process works therein.

5. The apparatus according to claim 4, characterized in that said first and second susceptors (2, 5) have respective coaxial vertical axes and in use are rotated in mutually opposite directions about their axes.

6. The apparatus according to claim 5, characterized in that the outer periphery of said first susceptor and inner periphery of said second susceptor are inclined with respect to said axes.

7. An apparatus for forming thin films, comprising:
a reaction furnace (1);
a first susceptor (2) disposed in said reaction furnace and having an outer periphery constituted by a heat reflection material and capable of supporting a plurality of semiconductor wafers (4) and being coaxially disposed in
a second hollow cup-shaped susceptor (5) disposed in said reaction furnace such as to surround said first susceptor (2) at a predetermined radial space therefrom and having an inner periphery constituted by a heat reflection material and capable of supporting a plurality of semiconductor wafers (4) such that these semiconductor wafers face the semiconductor wafers supported by said first susceptor (2);
a pair of heat reflection members (11, 12) disposed in said reaction furnace between the outer periphery of said first susceptor and the inner periphery of said second susceptor, so that the said members (11, 12) define the top and bottom of the said space which is formed between the first and second susceptors (2, 5);
rotating means (8) for causing relative rotation of said first and second susceptors to each other;
fluid supply means (9, 10) for supplying a reaction fluid to the space in said reaction furnace between the outer periphery of said first susceptor and the inner periphery of said second susceptor;
fluid exhausting means (7, 15) for exhausting the reaction fluid from the space in said reaction furnace between the outer periphery of said first susceptor and the inner periphery of said second susceptor; and
heating means (13) for heating the reaction fluid in said reaction furnace.

8. The apparatus according to claim 7, characterized in that said heat reflection members (11, 12) are provided on and rotatable with said respective first and second susceptors.

9. The apparatus according to claim 8, characterized in that said reaction fluid supply means is secured to said first susceptor (2) for rotation in unison with said first susceptor.

## Patentansprüche

1. Vorrichtung zum Herstellen von Dünnschichten, die aufweist:
einen Reaktionsofen (1); gekennzeichnet durch
einen ersten Sekundärzylinder (2), der in dem Reaktionsofen angeordnet ist und einen Außenumfang hat, der fähig ist, eine Vielzahl von zu behandelnden Werkstücken (4) zu tragen, und koaxial angeordnet ist in
einem zweiten hohlen becherförmigen Sekundärzylinder (5), der in dem Reaktionsofen angeordnet ist, um den ersten Sekundärzylinder (2) mit einem vorbestimmten radialen Raum dazwischen zu umgeben, und einen Innenumfang hat, der fähig ist, eine Vielzahl von zu behandelnden Werkstücken (4) derart zu tragen, daß diese zu behandelnden Werkstücke zu behandelnden Werkstücken zugewandt sind, die von dem ersten Sekundärzylinder (2) getragen sind;
eine Dreheinrichtung (8), um eine relative Drehung des ersten und des zweiten Sekundärzylinders (2, 5) zueinander zu bewirken;
eine Einrichtung (9, 10), um dem Raum in dem Reaktionsofen zwischen dem Außenumfang des ersten Sekundärzylinders und dem Innenumfang des zweiten Sekundärzylinders ein Reaktionsfluid zuzuführen; und
eine Einrichtung (7, 15), um das Reaktionsfluid aus dem Raum in dem Reaktionsofen zwischen dem Außenumfang des ersten Sekundärzylinders und der Innenfläche des zweiten Sekundärzylinders abzusaugen.

2. Vorrichtung nach Anspruch 1, dadurch gekennzeichnet, daß der Außenumfang des ersten Sekundärzylinders (2) eine Vielzahl von flachen Oberflächen hat, die nebeneinander in der Umfangsrichtung angeordnet sind, wobei jede der flachen Oberflächen fähig ist, mindestens ein zu behandelndes Werkstück zu tragen.

3. Vorrichtung nach Anspruch 2, dadurch gekennzeichnet, daß der Innenumfang des zweiten Sekundärzylinders (5) eine Vielzahl von flachen Oberflächen hat, die nebeneinander in der Umfangsrichtung angeordnet sind, wobei jede der flachen Oberflächen fähig ist, mindestens ein zu behandelndes Werkstück zu tragen.

4. Vorrichtung nach Anspruch 3, dadurch gekennzeichnet, daß die flachen Oberflächen des ersten und des zweiten Sekundärzylinders (2, 5) Ausnehmungen haben, um zu behandelnde Werkstücke darin aufzunehmen.

5. Vorrichtung nach Anspruch 4, dadurch gekennzeichnet, daß der erste und der zweite Sekundärzylinder (2, 5) koaxiale Vertikalachsen haben und im Gebrauch in zueinander entgegengesetzten Richtungen um ihre Achsen gedreht werden.

6. Vorrichtung nach Anspruch 5, dadurch gekennzeichnet, daß der Außenumfang des ersten Sekundärzylinders und der Innenumfang des zweiten Sekundärzylinders in bezug auf die genannten Achsen geneigt sind.

7. Vorrichtung zum Herstellen von Dünnschichten, die aufweist:
einen Reaktionsofen (1);
einen ersten Sekundärzylinder (2), der in dem Reaktionsofen angeordnet ist und einen Außenumfang hat, der aus einem wärmereflektierenden Material gebildet und fähig ist, eine Vielzahl von Halbleiterscheiben (4) zu tragen, und koaxial angeordnet ist in
einem zweiten hohlen becherförmigen Sekundärzylinder (5), der in dem Reaktionsofen angeordnet ist, um den ersten Sekundärzylinder (2) mit einem vorbestimmten radialen Raum dazwischen zu umgeben, und einen Innenumfang hat, der aus einem wärmereflektierenden Material gebildet und fähig ist, eine Vielzahl von Halbleiterscheiben (4) derart zu tragen, daß diese Halbleiterscheiben den Halbleiterscheiben zugewandt sind, die von dem ersten Sekundärzylinder (2) getragen sind;
ein Paar von wärmereflektierenden Elementen (11, 12), die in dem Reaktionsofen zwischen dem Außenumfang des ersten Sekundärzylinders und dem Innenumfang des zweiten Sekundärzylinders angeordnet sind, so daß die genannten Elemente (11, 12) das obere und das untere Ende des genannten Raums definieren, der zwischen dem ersten und dem zweiten Sekundärzylinder (2, 5) gebildet ist;
eine Dreheinrichtung (8), um eine relative Drehung des ersten und des zweiten Sekundärzylinders zueinander zu bewirken;
eine Fluidzufuhreinrichtung (9, 10), um dem Raum in dem Reaktionsofen zwischen dem Außenumfang des ersten Sekundärzylinders und dem Innenumfang des zweiten Sekundärzylinders ein Reaktionsfluid zuzuführen;
eine Fluidabsaugeinrichtung (7, 15), um das Reaktionsfluid aus dem Raum in dem Reaktionsofen zwischen dem Außenumfang des ersten Sekundärzylinders und dem Innenumfang des zweiten Sekundärzylinders abzusaugen; und
eine Heizeinrichtung (13), um das Reaktionsfluid in dem Reaktionsofen aufzuheizen.

8. Vorrichtung nach Anspruch 7, dadurch gekennzeichnet, daß die wärmereflektierenden Elemente (11, 12) auf dem jeweiligen ersten und zweiten Sekundärzylinder vorgesehen und damit drehbar sind.

9. Vorrichtung nach Anspruch 8, dadurch gekennzeichnet, daß die Reaktionsfluidzufuhreinrichtung an dem ersten Sekundärzylinder (2) befestigt ist, um synchron mit dem ersten Sekundärzylinder zu drehen.

## Revendications

1. Appareil pour former des films minces, comprenant un four de réaction (1), caractérisé en ce qu'il comprend :
- un premier support (2) disposé dans ce four de réaction, ayant une surface périphérique extérieure susceptible de supporter une multiplicité de pièces à traiter (4) et disposé coaxialement dans
- un deuxième support creux (5) en forme de coupe, disposé dans ce four de réaction de façon à entourer le premier support (2) en en étant radialement espacé d'une distance prédéterminée et ayant une surface périphérique intérieure susceptible de supporter une multiplicité de pièces à traiter (4) de manière que ces pièces à traiter soient en face des pièces à traiter supportées sur le premier support (2);
- des moyens de rotation (8) pour faire tourner le premier support (2) et le deuxième support (5) relativement l'un par rapport à l'autre;
- des moyens (9,10) pour amener un fluide de réaction dans l'espace dans le four de réaction compris entre la surface périphérique extérieure du premier support et la surface périphérique intérieure du deuxième support; et
- des moyens (7,15) pour évacuer le fluide de réaction de l'espace dans le four de réaction compris entre la surface périphérique extérieure du premier support et la surface périphérique intérieure du deuxième support.

2. Appareil selon la revendication 1, caractérisé en ce que la périphérie extérieure du premier support (2) a une multiplicité de surfaces plates disposées côte à côte dans la direction périphérique, chacune de ces surfaces plates étant susceptible de supporter au moins une pièce à traiter.

3. Appareil selon la revendication 2, caractérisé en ce que la périphérie intérieure du deuxième support (5) a une multiplicité de surfaces plates disposées côte à côte dans la direction périphérique, chacune de ces surfaces plates étant susceptible de supporter au moins une pièce à traiter.

4. Appareil selon la revendication 3, caractérisé en ce que les surfaces plates des premier et deuxième supports (2,5) ont des cavités pour y recevoir des pièces à traiter.

5. Appareil selon la revendication 4, caractérisé en ce que les premier et deuxième supports (2,5) ont des axes verticaux respectifs coaxiaux et qu'en utilisation, ils tournent autour de leurs axes respectifs dans des sens opposés l'un à l'autre.

6. Appareil selon la revendication 5, caractérisé en ce que la surface périphérique extérieure du premier support et la surface périphérique intérieure du deuxième support sont inclinées sur lesdits axes.

7. Appareil pour former des films minces, comprenant :
- un four de réaction (1);
- un premier support (2) disposé dans ce four de réaction, ayant une surface périphérique extérieure constituée par un matériau réfléchissant la chaleur, susceptible de supporter une multiplicité de pastilles semi-conductrices (4) et disposé coaxialement dans
- un deuxième support creux (5) en forme de coupe, disposé dans ce four de réaction de façon à entourer le premier support (2) en en étant radialement espacé d'une distance prédéterminée, ayant une surface périphérique intérieure constituée par un matériau réfléchissant la chaleur et susceptible de supporter une multiplicité de pastilles semi-conductrices (4) de manière que ces pastilles semi-conductrices soient en face des pastilles semi-conductrices supportées par le premier support (2);
- deux éléments réfléchissant la chaleur (11,12) disposés dans le four de réaction entre la surface périphérique extérieure du premier support et la surface périphérique intérieure du deuxième support, de telle sorte que ces éléments (11,12) définissent la partie supérieure et la partie de fond de cet espace formé entre les premier et deuxième supports (2,5);
- des moyens de rotation (8) pour faire tourner le premier support et le deuxième support relativement l'un par rapport à l'autre;
- des moyens de fourniture de fluide (9,10) pour amener un fluide de réaction dans l'espace dans le four de réaction compris entre la surface périphérique extérieure du premier support et la surface périphérique intérieure du deuxième support;
- des moyens d'évacuation de fluide (7,15) pour évacuer le fluide de réaction de l'espace dans le four de réaction compris entre la surface périphérique extérieure du premier support et la surface périphérique intérieure du deuxième support; et
- des moyens de chauffage (13) pour chauffer le fluide de réaction dans le four de réaction.

8. Appareil selon la revendication 7, caractérisé en ce que les éléments réfléchissant la chaleur (11,12) sont prévus sur les premier et deuxième supports respectivement et peuvent tourner avec eux.

9. Appareil selon la revendication 8, caractérisé en ce que les moyens de fourniture du fluide de réaction sont fixés sur le premier support (2) pour tourner à l'unisson avec ce premier support.
